# FASCICULE DE BREVET EUROPEEN

(11) **EP 4 002 017 B1**
(45) Date de publication et mention de la délivrance du brevet: **25.02.2026**
(21) Numéro de dépôt: 20207433.2
(22) Date de dépôt: 13.11.2020
(51) Int. Cl.: G04B 37/22, C23C 14/06, C23C 14/08, C23C 14/48, H01F 41/02, G04C 5/00

(54) **PROTECTION ANTI-CORROSION D AIMANTS D HORLOGERIE, NOTAMMENT NÉODYME-FER-BORE**
ANTIKORROSIONSSCHUTZ VON UHRWERKSMAGNETEN, INSBESONDERE VOM NEODYM-EISEN-BOR-TYP
ANTI-CORROSION PROTECTION FOR TIMEPIECE MAGNETS, IN PARTICULAR NEODYMIUM-IRON-BORON

(43) Date de publication de la demande: 25.05.2022
(73) Titulaire: Comadur S.A., 2400 Le Locle (CH)
(72) Inventeur: AMHERD-HIDALGO, Alexandra, 2000 Neuchâtel (CH); BOULMAY, Alexis, 25800 Valdahon (FR); VUILLE, Pierry, 2338 Les Emibois (CH)
(74) Mandataire: ICB SA

(56) Documents cités:
- EP-B1- 3 182 219
- WO-A1-2016/041772
- CN-A- 102 864 430
- CN-A- 102 864 432
- FR-A1- 2 768 551
- JP-A- 2006 049 801
- US-A- 5 154 978

## Description

### Domaine de l'invention

L'invention concerne un procédé de protection d'aimant néodyme-fer-bore d'horlogerie contre la corrosion, caractérisé en ce qu'on se munit d'un aimant en néodyme-fer-bore, qu'on effectue une préparation de surface dudit aimant, avant de le soumettre à un traitement d'implantation ionique, pour créer une couche superficielle étanche faisant barrière à l'oxydation avec la totalité des liaisons de surface saturées par les ions implantés, pour prévenir la corrosion dudit aimant en ambiance humide, dans les conditions usuelles de porter de montres.

L'invention concerne le domaine de la protection contre la corrosion des pièces d'horlogerie, en particulier des montres, qui peuvent être soumises à de très gros écarts de température et d'hygrométrie dans les conditions d'utilisation pour lesquelles elles sont garanties, à la surface du globe pour les montres tout public, mais aussi, pour des utilisateurs particuliers, dans le domaine spatial et le domaine sous-marin.

### Arrière-plan de l'invention

Les aimants sont sensibles à la corrosion, et il est difficile de les protéger efficacement.

Toutefois, la couche déposer doit être bon marché, avec notamment une application peu coûteuse, bien résister à la corrosion due à l'humidité, ne pas diminuer les propriétés magnétiques, et montrer une certaine résistance mécanique. Ces contraintes sont encore mal dominées par des solutions connues, qui consistent à déposer sur leur surface des couches Al₂O₃, SiO₂, époxy, ou encore de nickel.

On connait de l'état de la technique le document FR2768551 décrivant un aimant plat comportant une couche de revêtement permettant d'améliorer les propriétés magnétiques de l'aimant. Le document prévoit l'ajout d'additifs dans le revêtement afin d'améliorer les propriétés mécaniques ou la résistance à la corrosion.

### Résumé de l'invention

L'invention se propose de réaliser la confection d'une couche de protection anti-corrosion sur des aimants d'horlogerie, et en particulier sur des aimants en NdFeB, par implantation ionique.

A cet effet, l'invention concerne un procédé de protection d'aimant d'horlogerie contre la corrosion, selon la revendication 1 ou 3 annexée.

### Description détaillée des modes de réalisation préférés

L'invention concerne un procédé de protection d'aimant néodyme-fer-bore d'horlogerie contre la corrosion, caractérisé en ce qu'on se munit d'un aimant en néodyme-fer-bore, qu'on effectue une préparation de surface dudit aimant, avant de le soumettre à un traitement d'implantation ionique, pour créer une couche superficielle étanche faisant barrière à l'oxydation avec la totalité des liaisons de surface saturées par les ions implantés, pour prévenir la corrosion dudit aimant en ambiance humide, dans les conditions usuelles de porter de montres.

La technologie d'implantation ionique permet de venir créer une barrière à l'oxydation naturelle, en saturant la couche superficielle, notamment la couche d'oxyde ou nitrure dans le cas d'un traitement ionique d'implantation sous oxygène ou respectivement sous azote.

Cette couche de saturation est créée en venant accélérer les ions multichargé d'un plasma d'O₂, N₂, ou autre, avec une différence de potentiel comprise entre 10 kV et 40 kV. Les ions viennent ainsi se densifier à la surface, à des profondeur différentes (en fonction de la charge de l'ion) faisant en extrême surface une barrière à l'oxydation, les liaisons de surface étant toutes saturées par les ions implantés.

Plus particulièrement, pour la mise en oeuvre du procédé selon l'invention, on se munit d'un aimant en néodyme-fer-bore, avec de 22% à 24% en masse de néodyme, de 65% à 67% en masse de fer, de 0.1% à 2% en masse de bore, le total étant de 100%, qu'on effectue une préparation de surface du aimant, avant de le soumettre à un traitement d'implantation ionique, pour créer une couche superficielle d'oxydation ou de nitruration étanche, pour prévenir la corrosion du aimant en ambiance humide, dans les conditions usuelles de porter de montres.

Selon l'invention telle que définie dans la revendication indépendante 1 annexée, on effectue un traitement d'implantation ionique d'oxydation, sous oxygène, avec une tension de 10 kV à 40 kV.

Plus particulièrement, on effectue un traitement d'implantation ionique d'oxydation, sous oxygène, avec une tension de 24 kV à 26 kV, une puissance de faisceau de 5 mA à 7 mA, et une dose de 20. 10¹⁶ à 30. 10¹⁶ ions par centimètre carré.

Selon l'invention telle que définie dans la revendication indépendante 3 annexé, on effectue un traitement d'implantation ionique de nitruration, sous azote, avec une tension de 10 kV à 40 kV.

Plus particulièrement, on effectue un traitement d'implantation ionique de nitruration, sous azote, avec une tension de 24 kV à 26 kV, une puissance de faisceau de 5 mA à 7 mA, et une dose de 20. 10¹⁶ à 30. 10¹⁶ ions par centimètre carré.

Plus particulièrement, on effectue la préparation de surface de l'aimant par un sablage suivi d'un rinçage à l'alcool et d'un séchage à l'air.

Plus particulièrement, on effectue le sablage avec des particules d'alumine d'une taille de 200 mesh à 240 mesh, avec une pression de 1.4 à 1.8 bar, et une distance de 13 mm à 17 mm entre le flux et la surface à sabler.

Plus particulièrement, on applique le procédé à un aimant d'épaisseur inférieure ou égale à 1.0 mm, et dont la plus grande dimension est inférieure ou égale à 8.0 mm.

Plus particulièrement, on applique le procédé à un aimant d'épaisseur inférieure ou égale à 0.6 mm, et dont la plus grande dimension est inférieure ou égale à 5.0 mm.

Plus particulièrement, on applique le procédé à un aimant percé d'un orifice traversant dont la plus grande dimension est comprise entre 0.2 mm et 3.0 mm.

Dans une application horlogère non limitative, un aimant sous forme de toroïde ou de cylindre, en NdFeB, qui a des dimensions de l'ordre de 0.9 mm à 5.0 mm comme diamètre extérieur, avec un orifice traversant d'un diamètre intérieur de l'ordre de 0.21 mm à 3.0 mm, et une épaisseur de l'ordre de 0.15 mm à 0.55 mm, est soumis au traitement d'implantation ionique pour créer une couche d'oxydation ou nitruration étanche, qui évite la corrosion de l'aimant dans des ambiances humides.

Des aimants traités par cette technique sont contrôlés visuellement avant et après un test de vieillissement accéléré (7 jours à 60 degrés Celsius et 90% d'humidité relative).

Le procédé se révèle très efficace pour un aimant en néodyme-fer-bore, avec 23%% en masse de néodyme, 66% en masse de fer, et 1% en masse de bore
Le contrôle visuel d'aimants de même type, mais sans traitement, montre de la corrosion rouge typique de la matière NdFeB. Par contre, quand le traitement par implantation ionique sous oxygène selon l'invention est réalisé, cette corrosion ne se produit pas.

Le traitement d'implantation ionique par oxygène crée une barrière d'oxydation à la surface de l'aimant. La surface devient dans un état dans lequel la vitesse de corrosion est notablement ralentie par la présence d'un état de surface passif artificiel, par rapport à ce qu'elle serait en l'absence de cette couche d'oxyde.

La nitruration par implantation ionique permet, quant à elle, d'incorporer de l'azote dans la surface de l'aimant. L'azote réagit avec le fer en diffusant sur les couches superficielles de l'aimant. Une couche de nitrures de fer est créée à la surface, qui empêche la pénétration de l'oxygène à l'intérieur des pièces.

Les résultats montrent ainsi que la protection par implantation ionique de l'oxygène ou de l'azote permettre de protéger la matière NdFeB contre la corrosion (60°Celsius et 90%d'humidité relative pendant 7 jours). Les deux couches, obtenues avec ces deux variantes du procédé selon l'invention, apportent chacune une protection régulière, stable, et dense, qui assure une protection efficace contre la corrosion.

L'invention présente ainsi des avantages notables :
- bonne résistance à la corrosion ;
- technologie innovante et verte, car nécessitant une faible consommation de gaz, et génératrice de peu voire pas de rejets;
- absence de risque de délamination, puisque le traitement est effectué dans la matière elle-même, et non en recouvrement ;
- procédé répétable et de mise au point facile ;
- réalisation d'une couche de protection avec perte magnétique négligeable ;
- réalisation d'une couche de protection avec une résistance mécanique convenable.

## Revendications

1. Procédé de protection d'aimant d'horlogerie contre la corrosion, **caractérisé en ce qu'**on se munit d'un aimant, qu'on effectue une préparation de surface dudit aimant, avant de le soumettre à un traitement d'implantation ionique, pour créer une couche superficielle étanche faisant barrière à l'oxydation avec la totalité des liaisons de surface saturées par les ions implantés, pour prévenir la corrosion dudit aimant en ambiance humide, dans les conditions usuelles de porter de montres, **caractérisé en ce que** le traitement d'implantation ionique est un traitement d'implantation ionique d'oxydation, sous oxygène, avec une tension de 10 kV à 40 kV.

2. Procédé selon la revendication 1, **caractérisé en ce qu'**on effectue un dit traitement d'implantation ionique d'oxydation, sous oxygène, avec une tension de 24 kV à 26 kV, une puissance de faisceau de 5 mA à 7 mA, et une dose de 20. 10¹⁶ à 30. 10¹⁶ ions par centimètre carré.

3. Procédé de protection d'aimant d'horlogerie contre la corrosion, **caractérisé en ce qu'**on se munit d'un aimant, qu'on effectue une préparation de surface dudit aimant, avant de le soumettre à un traitement d'implantation ionique, pour créer une couche superficielle étanche faisant barrière à l'oxydation avec la totalité des liaisons de surface saturées par les ions implantés, pour prévenir la corrosion dudit aimant en ambiance humide, dans les conditions usuelles de porter de montres, **caractérisé en ce que** le traitement d'implantation ionique est un traitement d'implantation ionique de nitruration, sous azote, avec une tension de 10 kV à 40 kV.

4. Procédé selon la revendication 3, **caractérisé en ce qu'**on effectue un dit traitement d'implantation ionique de nitruration, sous azote, avec une tension de 24 kV à 26 kV, une puissance de faisceau de 5 mA à 7 mA, et une dose de 20. 10¹⁶ à 30. 10¹⁶ ions par centimètre carré.

5. Procédé selon l'une des revendications 1 à 4, **caractérisé en ce qu'**on effectue ladite préparation de surface dudit aimant par un sablage suivi d'un rinçage à l'alcool et d'un séchage à l'air.

6. Procédé selon la revendication 5, **caractérisé en ce qu'**on effectue ledit sablage avec des particules d'alumine d'une taille de 200 mesh à 240 mesh, avec une pression de 1.4 à 1.8 bar, et une distance de 13 mm à 17 mm entre le flux et la surface à sabler.

7. Procédé selon l'une des revendications 1 à 6, **caractérisé en ce qu'**on applique ledit procédé à un aimant d'épaisseur inférieure ou égale à 1.0 mm, et dont la plus grande dimension est inférieure ou égale à 8.0 mm.

8. Procédé selon la revendication 7, **caractérisé en ce qu'**on applique ledit procédé à un aimant d'épaisseur inférieure ou égale à 0.6 mm, et dont la plus grande dimension est inférieure ou égale à 5.0 mm.

9. Procédé selon la revendication 7 ou 8, **caractérisé en ce qu'**on applique ledit procédé à un aimant percé d'un orifice traversant dont la plus grande dimension est comprise entre 0.2 mm et 3.0 mm.

## Patentansprüche

1. Verfahren zum Schutz eines Uhrenmagneten gegen Korrosion, **dadurch gekennzeichnet, dass** ein Magnet bereitgestellt wird und dass der Magnet oberflächenbehandelt wird, bevor er einer lonenimplantationsbehandlung unterzogen wird, um eine wasserdichte Oberflächenschicht zu erzeugen, die als eine Oxidationsbarriere wirkt, wobei sämtliche Oberflächenbindungen mit den implantierten Ionen gesättigt sind, um Korrosion des Magneten in feuchter Umgebung, unter normalen Bedingungen für das Tragen von Uhren, zu verhindern, **dadurch gekennzeichnet, dass** die lonenimplantationsbehandlung eine Oxidationsionenimplantationsbehandlung, in Sauerstoff, mit einer Spannung von 10 kV bis 40 kV ist.

2. Verfahren nach Anspruch 1, **dadurch gekennzeichnet, dass** die Oxidationsionenimplantationsbehandlung in Sauerstoff mit einer Spannung von 24 kV bis 26 kV, einer Strahlstärke von 5 mA bis 7 mA und einer Dosis von 20 x 10¹⁶ bis 30 × 10¹⁶ Ionen pro Quadratzentimeter durchgeführt wird.

3. Verfahren zum Schutz eines Uhrenmagneten gegen Korrosion, **dadurch gekennzeichnet, dass** ein Magnet bereitgestellt wird und dass der Magnet oberflächenbehandelt wird, bevor er einer lonenimplantationsbehandlung unterzogen wird, um eine wasserdichte Oberflächenschicht zu erzeugen, die als eine Oxidationsbarriere wirkt, wobei sämtliche Oberflächenbindungen mit den implantierten Ionen gesättigt sind, um Korrosion des Magneten in feuchter Umgebung, unter normalen Bedingungen für das Tragen von Uhren, zu verhindern, **dadurch gekennzeichnet, dass** die lonenimplantationsbehandlung eine Oxidationsionenimplantationsbehandlung, in Stickstoff, mit einer Spannung von 10 kV bis 40 kV ist.

4. Verfahren nach Anspruch 3, **dadurch gekennzeichnet, dass** die Nitrierungsionenimplantationsbehandlung in Stickstoff mit einer Spannung von 24 kV bis 26 kV, einer Strahlstärke von 5 mA bis 7 mA und einer Dosis von 20 × 10¹⁶ bis 30 × 10¹⁶ Ionen pro Quadratzentimeter durchgeführt wird.

5. Verfahren nach einem der Ansprüche 1 bis 4, **dadurch gekennzeichnet, dass** die Oberflächenbehandlung an dem Magneten durch Sandstrahlen und anschließendes Spülen mit Alkohol und Lufttrocknen durchgeführt wird.

6. Verfahren nach Anspruch 5, **dadurch gekennzeichnet, dass** das Sandstrahlen unter Verwendung von Aluminiumoxidteilchen mit einer Teilchengröße von 200 mesh bis 240 mesh, bei einem Druck von 1,4 bis 1,8 bar und mit einem Abstand von 13 mm bis 17 mm zwischen dem Strom und der zu sandstrahlenden Oberfläche durchgeführt wird.

7. Verfahren nach einem der Ansprüche 1 bis 6, **dadurch gekennzeichnet, dass** das Verfahren auf einen Magneten mit einer Dicke von weniger als oder gleich 1,0 mm und einer größten Abmessung von weniger als oder gleich 8,0 mm angewendet wird.

8. Verfahren nach Anspruch 7, **dadurch gekennzeichnet, dass** das Verfahren auf einen Magneten mit einer Dicke von weniger als oder gleich 0,6 mm und einer größten Abmessung von weniger als oder gleich 5,0 mm angewendet wird.

9. Verfahren nach Anspruch 7 oder 8, **dadurch gekennzeichnet, dass** das Verfahren auf einen Magneten angewendet wird, der mit einem Durchgangsloch perforiert ist, in dem die größte Abmessung zwischen 0,2 mm und 3,0 mm beträgt.

## Claims

1. A method for protecting a horology magnet against corrosion, **characterised in that** a magnet is provided, that said magnet is surface-treated before being exposed to an ion implantation treatment, in order to create an impervious surface layer acting as a barrier to oxidation, with all surface bonds saturated by the implanted ions, to prevent corrosion of said magnet in a humid environment, under normal conditions for wearing watches, **characterised in that** the ion implantation treatment is an oxidation ion implantation treatment, in oxygen, with a voltage of from 10 kV to 40 kV.

2. The method according to claim 1, **characterised in that** a said oxidising ion implantation treatment is carried out, in oxygen, with a voltage of from 24 kV to 26 kV, a beam power of from 5 mA to 7 mA, and a dose of from 20 × 10¹⁶ to 30 × 10¹⁶ ions per square centimetre.

3. A method for protecting a horology magnet against corrosion, **characterised in that** a magnet is provided, that said magnet is surface-treated before being exposed to an ion implantation treatment, in order to create an impervious surface layer acting as a barrier to oxidation, with all surface bonds saturated by the implanted ions, to prevent corrosion of said magnet in a humid environment, under normal conditions for wearing watches, **characterised in that** the ion implantation treatment is an oxidation ion implantation treatment, in nitrogen, with a voltage of from 10 kV to 40 kV.

4. The method according to claim 3, **characterised in that** a said nitriding ion implantation treatment is carried out, in nitrogen, with a voltage of from 24 kV to 26 kV, a beam power of from 5 mA to 7 mA, and a dose of from 20 × 10¹⁶ to 30 × 10¹⁶ ions per square centimetre.

5. The method according to any of claims 1 to 4, **characterised in that** said surface treatment is carried out on said magnet by sandblasting followed by rinsing with alcohol and air drying.

6. The method according to claim 5, **characterised in that** said sandblasting is carried out using alumina particles with a particle size of from 200 mesh to 240 mesh, at a pressure of from 1.4 to 1.8 bar, and with a distance of from 13 mm to 17 mm between the flux and the surface to be sandblasted.

7. The method according to any of claims 1 to 6, **characterised in that** said method is applied to a magnet with a thickness of less than or equal to 1.0 mm and a largest dimension of less than or equal to 8.0 mm.

8. The method according to claim 7, **characterised in that** said method is applied to a magnet with a thickness of less than or equal to 0.6 mm and a largest dimension of less than or equal to 5.0 mm.

9. The method according to claim 7 or 8, **characterised in that** said method is applied to a magnet that is perforated with a through-hole in which the largest dimension is comprised between 0.2 mm and 3.0 mm.
